# EUROPEAN PATENT APPLICATION

(11) **EP 4 761 095 A1**
(43) Date of publication of application: **17.06.2026**
(21) Application number: 25221687.4
(22) Date of filing: 09.12.2025
(51) Int. Cl.: H02M 7/5395, H02M 3/335, H02M 7/162, H02M 7/217, H02M 1/44, H02M 3/00, H02M 7/00, B60L 53/22

(54) **POWER SUPPLY MODULE**

(30) Priority: 16.12.2024 JP 2024219667
(71) Applicant: AISIN CORPORATION, Aichi 448-8650 (JP)
(72) Inventor: GOTO, Kenta, Kariya 448-8650 (JP); KOASHI, Hidefumi, Kariya 448-8650 (JP); MIZUNO, Yuya, Kariya 448-8650 (JP); TAKEMOTO, Keisuke, Kariya 448-8650 (JP); NAGAI, Yuki, Kariya 448-8650 (JP); HANAMURA, Takuya, Kariya 448-8650 (JP); SUGIMOTO, Noriaki, Kariya 448-8650 (JP); UMEBAYASHI, Shinya, Kariya 448-8650 (JP)
(74) Representative: Kramer Barske Schmidtchen Patentanwälte PartG mbB

(57) **Abstract**

A characteristic configuration of a power supply module according to the present disclosure includes a power supply module (1) mounted on a vehicle, the power supply module (1) including an AC-DC conversion unit **(11)** that converts one of an AC voltage and a DC voltage into the other and outputs the other, and a voltage conversion unit (20) that converts a first voltage value of an input DC voltage into a DC voltage having a second voltage value, the voltage conversion unit (20) includes a first conversion unit (21) connected to the AC-DC conversion unit (11) and a second conversion unit (23) connected to the first conversion unit (21) via a transformer (22), and the power supply module (1) including a first board (81) on which the AC-DC conversion unit (11) and the first conversion unit (21) are provided, and a second board (82) on which the second conversion unit (23) is provided and that is different from the first board (81).

## Description

### TECHNICAL FIELD

The present disclosure relates to a power supply module mounted on a vehicle.

### BACKGROUND DISCUSSION

For example, a battery for driving a motor is mounted on electric vehicles that travel using electric energy such as automobiles including a motor as a traveling drive source (a hybrid electric vehicle (HEV), a plug-in hybrid electric vehicle (PHEV), a battery electric vehicle (BEV), a fuel cell electric vehicle (FCEV), and the like). In the case of charging the battery or in the case of using power stored in the battery, a power supply module that converts a DC voltage having a predetermined voltage value into a DC voltage having an expected voltage value is used. As a technique related to such a power supply module, for example, there is a technique described in Japanese Patent Application Laid-Open No. 2016-111748 whose source is described below.

Japanese Patent Application Laid-Open No. 2016-111748 describes a power conversion device (an example of the power supply module). The power conversion device includes an AC/DC converter and a DC/DC converter, the AC/DC converter is disposed on an upper surface side of a cooling chassis, and the DC/DC converter is disposed on a lower surface side of the cooling chassis.

In the power conversion device described in Japanese Patent Application Laid-Open No. 2016-111748, the DC/DC converter disposed on the lower surface side of the cooling chassis includes a circuit block that outputs a high-voltage DC and a circuit block that outputs a low-voltage DC, and these two circuit blocks are mounted on one board. For this reason, the size of the board increases, and its handling in a manufacturing process or an inspection process is not easy. In addition, since the circuit block that outputs the high-voltage DC differs from the circuit block that outputs the low-voltage DC in the current value of the current flowing through each circuit block, it is conceivable to change the layer configuration of the board and the thickness of the conductor layer depending on each current value. However, since the circuit blocks are mounted on a single board, the specifications of the circuit block having a large current value have to be adapted. As a result, this causes an increase in cost. Therefore, the power conversion device described in Japanese Patent Application Laid-Open No. 2016-111748 has room for improvement in terms of simplification and cost reduction.

Therefore, there is a need for a power supply module that is easily handled and can be obtained at low cost.

A need thus exists for a power supply module which is not susceptible to the drawback mentioned above.

### SUMMARY

A characteristic configuration of a power supply module according to the present disclosure includes a power supply module mounted on a vehicle, the power supply module including an AC-DC conversion unit that converts one of an AC voltage and a DC voltage into the other and outputs the other, and a voltage conversion unit that converts a first voltage value of an input DC voltage into a DC voltage having a second voltage value, the voltage conversion unit includes a first conversion unit connected to the AC-DC conversion unit and a second conversion unit connected to the first conversion unit via a transformer, and the power supply module including a first board on which the AC-DC conversion unit and the first conversion unit are provided, and a second board on which the second conversion unit is provided and that is different from the first board.

With such a characteristic configuration, the first board on which the AC-DC conversion unit and the first conversion unit are provided and the second board on which the second conversion unit is provided, the first board and the second board being configured via the transformer, can be configured separately. Therefore, the first board and the second board can be easily assembled and inspected, and handling can be easily performed in a manufacturing process and an inspection process. In addition, since the layer configurations of the first board and the second board and the thickness of the conductor layer can be set depending on the specifications of the AC-DC conversion unit, the first conversion unit, and the second conversion unit, it is possible to configure each board at low cost.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a diagram illustrating a configuration of a circuit provided in a power supply module;
Fig. 2 is a plan view of a power conversion device including the power supply module;
Fig. 3 is a cross-sectional view taken along line III-III in Fig. 2; and
Fig. 4 is a diagram illustrating a connecting member.

### DETAILED DESCRIPTION

A power supply module according to the present disclosure is configured to be easily assembled to a power conversion device. Hereinafter, a power supply module 1 of the present embodiment will be described. Here, the power supply module 1 is not limited to the following embodiments, and various modifications can be made without departing from the gist thereof.

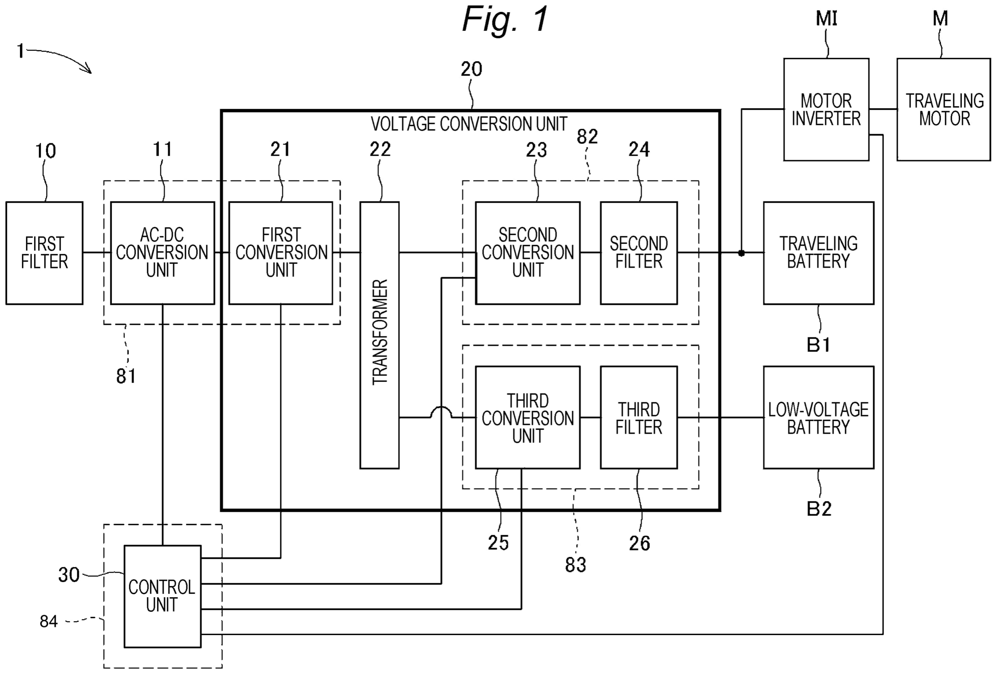

Fig. 1 is a diagram illustrating a circuit configuration of the power supply module 1. In the present embodiment, the power supply module 1 is used to charge a traveling battery B1 that stores power used for driving a vehicle traveling motor M, and to use power charged in the traveling battery B1. Therefore, the power supply module 1 is mounted on a vehicle. The traveling motor M is driven by a motor inverter MI on the basis of power stored in the traveling battery B1.

The traveling battery B1 is charged using, for example, a commercial power supply. The use of the power charged in the traveling battery B1 corresponds to, for example, generation of power equivalent to a commercial power supply using the power or generation of power based on a voltage having a different voltage value using the power. Specifically, the generation of power based on a voltage having a different voltage value corresponds to generation of power for charging a low-voltage battery B2.

Therefore, the power supply module 1 is mounted on a vehicle, and charges the traveling battery B1 that stores power used to drive the vehicle traveling motor M using a commercial power supply, generates power equivalent to the commercial power supply using the power charged in the traveling battery B1, and generates power for charging, for example, the low-voltage battery B2 using the power charged in the traveling battery B1.

As illustrated in Fig. 1, the power supply module 1 includes a first filter 10, an AC-DC conversion unit 11, a voltage conversion unit 20, and a control unit 30. The voltage conversion unit 20 includes a first conversion unit 21, a transformer 22, a second conversion unit 23, a second filter 24, a third conversion unit 25, and a third filter 26.

The first filter 10 is provided on the inverter side and attenuates noise superimposed on the input voltage and current. In a case where the traveling battery B1 is charged, the input voltage and current correspond to the voltage and current from the commercial power supply supplied from the outside. On the other hand, in a case where power equivalent to the commercial power supply is generated from the power of the traveling battery B1, the input voltage and current correspond to the voltage and current from the AC-DC conversion unit 11 to be described later.

The AC-DC conversion unit 11 converts one of an AC voltage and a DC voltage into the other and outputs the other. Converting one of the AC voltage and the DC voltage into the other means converting the AC voltage having the frequency of the commercial power supply (50 Hz or 60 Hz) into the DC voltage in a case where the traveling battery B1 is charged, and means converting the DC voltage from the voltage conversion unit 20 to be described later into the AC voltage having a frequency similar to that of the commercial power supply in a case where the power equivalent to the commercial power supply is generated from the power of the traveling battery B1. Therefore, the AC-DC conversion unit 11 converts the AC voltage into the DC voltage in a case where the AC voltage is input, and converts the DC voltage into the AC voltage in a case where the DC voltage is input.

The voltage conversion unit 20 converts a first voltage value of an input DC voltage into a DC voltage having a second voltage value. In a case where the traveling battery B1 is charged, the voltage conversion unit 20 converts the DC voltage from the AC-DC conversion unit 11 into a DC voltage having a voltage value suitable for charging the traveling battery B1 and the low-voltage battery B2. On the other hand, when the power equivalent to the commercial power supply is generated from the power of the traveling battery B1, the voltage conversion unit 20 converts a DC voltage from the traveling battery B1 into a DC voltage of a voltage suitable for conversion of an AC voltage similar to that of the commercial power supply.

The first conversion unit 21 is connected to the AC-DC conversion unit 11. In a case where DC power is supplied from the AC-DC conversion unit 11, the first conversion unit 21 amplitudes the DC power at a predetermined cycle and outputs the amplified DC power to the transformer 22. Furthermore, in a case where AC power is supplied from the transformer 22, the first conversion unit 21 converts the AC power into DC power and outputs the DC power to the AC-DC conversion unit 11. Here, "connection" in the present embodiment means electrical connection.

The second conversion unit 23 is connected to the first conversion unit 21 via the transformer 22. In a case where AC power is supplied from the transformer 22, the second conversion unit 23 converts the AC power into DC power and outputs the DC power to the second filter 24. Furthermore, in a case where DC power is supplied from the traveling battery B1 via the second filter 24, the second conversion unit 23 converts the DC power into AC power and outputs the AC power to the transformer 22.

The second filter 24 attenuates noise superimposed on the input voltage and current. In a case where the traveling battery B1 is charged, the input voltage and current correspond to the voltage and current supplied from the second conversion unit 23. On the other hand, in a case where power equivalent to the commercial power supply is generated from the power of the traveling battery B1, the input voltage and current correspond to the voltage and current from the traveling battery B1.

The third conversion unit 25 is connected to the first conversion unit 21 via the transformer 22. The third conversion unit 25 converts into a DC voltage having a third voltage value. In both the case where the power supply module 1 charges the traveling battery B1 and the case where the power of the traveling battery B1 is used, the third conversion unit 25 converts the AC power from the transformer 22 into a DC voltage of a voltage suitable for charging the low-voltage battery B2, and outputs the DC voltage to the third filter 26.

The third filter 26 attenuates noise superimposed on the input voltage and current. The input voltage and current correspond to the voltage and current supplied from the third conversion unit 25.

The control unit 30 controls driving of the AC-DC conversion unit 11, the voltage conversion unit 20, and the motor inverter MI. The AC-DC conversion unit 11, the voltage conversion unit 20, and the motor inverter MI each include a plurality of switching elements, and the control unit 30 controls these switching elements by switching between open and closed states.

The AC-DC conversion unit 11 and the first conversion unit 21 are provided on a first board 81. That is, the AC-DC conversion unit 11 and the first conversion unit 21 are provided on a single board. In addition, the second conversion unit 23 and the second filter 24 are provided on a second board 82 different from the first board 81. That is, the second conversion unit 23 and the second filter 24 are provided on a single board separated from the first board 81. Furthermore, the third conversion unit 25 and the third filter 26 are provided on a third board 83 different from the first board 81 and the second board 82. That is, the third conversion unit 25 and the third filter 26 are provided on a single board separated from both the first board 81 and the second board 82. Moreover, the control unit 30 is provided on a control board 84. The control board 84 is also a board separate from each of the first board 81, the second board 82, and the third board 83. In Fig. 1, reference numerals indicating the individual boards are also attached to facilitate understanding.

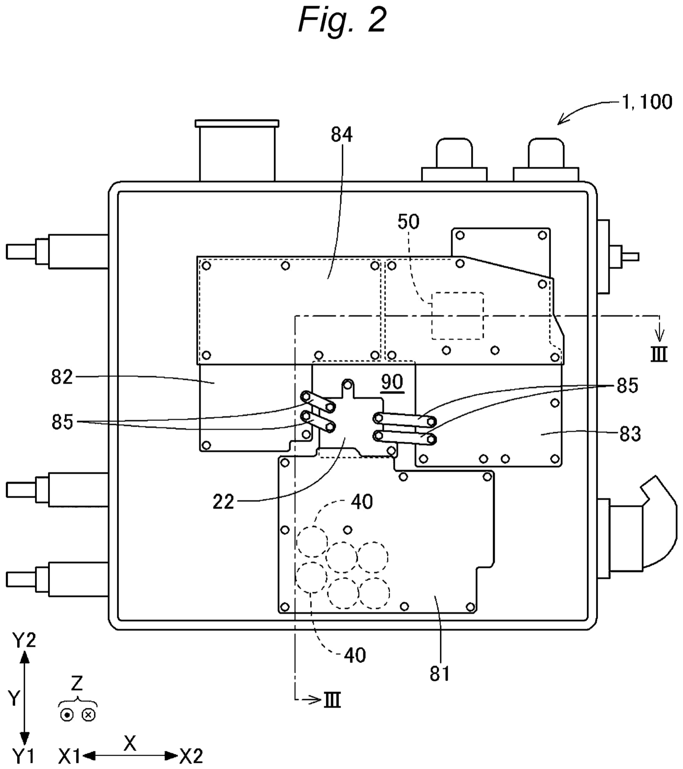

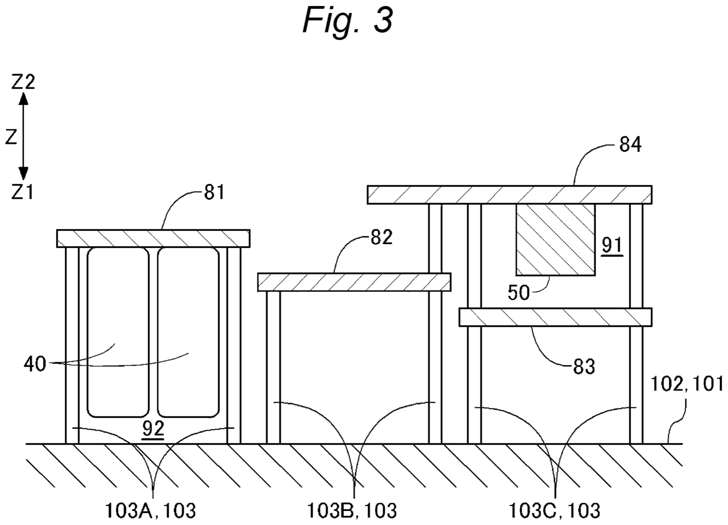

Fig. 2 is a plan view of a power conversion device 100 to which the power supply module 1 is assembled. In addition, Fig. 3 is a cross-sectional view taken along line III-III in Fig. 2. As illustrated in Fig. 2, the power conversion device 100 has a quadrangular shape in plan view. Hereinafter, a direction in which two sides of four sides constituting the quadrangular shape extend is referred to as an X direction, and a direction orthogonal to the X direction is referred to as a Y direction (an example of "second direction"). In addition, a direction orthogonal to both the X direction and the Y direction will be described as a Z direction (an example of "first direction").

As illustrated in Fig. 2, the first board 81, the second board 82, and the third board 83 are arranged around the transformer 22 in a state of having at least portions not overlapping each other as viewed in the Z direction along the thickness direction. In the present embodiment, the transformer 22 is provided in a central region with respect to the X direction and the Y direction as viewed in the Z direction of the power conversion device 100. The state having at least portions not overlapping each other includes a state not overlapping each other at all and a state partially overlapping each other.

The first board 81 is provided mainly on one side (the Y1 side) along the Y direction of the transformer 22. In the example of Fig. 2, the first board 81 partially overlaps the transformer 22 along the Z direction. The first board 81 is connected to a terminal erected from the transformer 22 toward the first board 81 at the overlapping portion. The second board 82 is provided in an L-shape as viewed in the Z direction on one side (the X1 side) along the X direction and the other side (the Y2 side) along the Y direction of the transformer 22. The third board 83 is provided on the other side (the X2 side) along the X direction of the transformer 22.

A space heat insulating portion 90 that suppresses mutual heat transfer is provided between at least one of the first board 81, the second board 82, and the third board 83 and the transformer 22. In the present embodiment, as illustrated in Fig. 2, the space heat insulating portion 90 is provided between the second board 82 and the transformer 22, and the space heat insulating portion 90 is also provided between the third board 83 and the transformer 22. The space heat insulating portion 90 is a gap provided with a predetermined width between the target board and the transformer 22. This width is preferably set in a manner that the influence on the target board depending on the heat of the transformer 22 can be reduced. Specifically, the width is preferably set in a manner that the influence of heat is equal to or less than a predetermined amount.

Therefore, the space heat insulating portion 90 is preferably provided between the transformer 22 and a region having a high heat generation density in at least one of the first board 81, the second board 82, and the third board 83. In the present embodiment, as described above, the space heat insulating portion 90 is provided between the second board 82 and the transformer 22, and the space heat insulating portion 90 is also provided between the third board 83 and the transformer 22. The high heat generation density means that the value obtained by dividing the amount of heat generation by the surface area of the board is large. Therefore, in the present embodiment, the space heat insulating portion 90 is preferably provided between the transformer 22 and a region where the value obtained by dividing the amount of heat generation by the surface area of the board is large in the second board 82 and the third board 83. As a result, even in a case where heat is generated from the transformer 22, thermal stress on the components provided on the second board 82 and the third board 83 can be reduced.

Furthermore, according to the power supply module 1 of the present embodiment, for example, even in a case where the output power is increased (specifically, in a case where the output power is changed from 3.3 kW to 6.6 kW), it is possible to cope with the case only by changing the first board 81 and the transformer 22. At this time, the size of the transformer 22 increases, but the transformer can be disposed using the region used as the space heat insulating portion 90, and thus the transformer 22 with an increased size can also be disposed.

As illustrated in Fig. 3, the first board 81, the second board 82, and the third board 83 are arranged in a state where their positions along the Z direction are different from each other as viewed in the Y direction. In the present embodiment, each of the first board 81, the second board 82, and the third board 83 is supported by a support 103 erected from a bottom surface 102 of a housing 101. Hereinafter, in order to facilitate understanding, the support 103 that supports the first board 81 will be described as a support 103A, the support 103 that supports the second board 82 will be described as a support 103B, and the support 103 that supports the third board 83 will be described as a support 103C. In the present embodiment, among the support 103A, the support 103B, and the support 103C, the support 103A has the longest length along the Z direction, and the support 103C has the shortest length along the Z direction. As a result, the first board 81, the second board 82, and the third board 83 are arranged at positions with different distances (heights) from the bottom surface 102 of the housing 101. Here, the housing 101 is a cooling plate for cooling a case that houses the power supply module 1 and a component attached to a board.

Furthermore, in the present embodiment, for the potentials applied to the first board 81, the second board 82, and the third board 83, the first board 81 is the highest and the third board 83 is the lowest. Therefore, the first board 81, the second board 82, and the third board 83 are arranged in descending order of applied potential from the side opposite to the bottom surface 102 of the housing 101. The side opposite to the bottom surface 102 is the Z2 side that is the opposite side to the Z1 side which is the bottom surface 102 side as viewed along the Z direction from each board. Therefore, the first board 81, the second board 82, and the third board 83 are arranged in descending order of applied potential from the Z2 side. As a result, for example, when a conductive foreign substance is generated, the conductive foreign substance rolls down to the low potential side, so that the insulation robustness is superior. In addition, since a region 92 on the Z1 side of the first board 81 can secure a long length along the Z direction, a relatively tall component (for example, a capacitor 40) can be disposed.

A lid portion (not illustrated) is provided on the Z2 side of the housing 101, but when the lid portion is provided along the XY plane, the Z2 side of the third board 83 has a larger space than the Z2 side of the first board 81, for example. Therefore, the control board 84 is disposed on the side opposite to the bottom surface 102 of at least one of the first board 81, the second board 82, and the third board 83 that is the closest to the bottom surface 102. That is, in the present embodiment, the control board 84 is disposed on the Z2 side of the third board 83. In the present embodiment, the control board 84 is disposed not only on the Z2 side of the third board 83 but also on the Z2 side of the second board 82.

In a case where the Z1 side is viewed from the control board 84, the length along the Z direction between the control board and the third board 83 is longer than the length along the Z direction between the control board and the second board 82. Therefore, in the control board 84, a relatively tall component 50 among the components provided on the control board 84 is provided in a region 91 in the control board 84 facing the third board 83 which is one of the first board 81, the second board 82, and the third board 83 that is the closest to the bottom surface 102. As a result, it is easy to secure a space for disposing the tall component 50, and for example, it is not necessary to take measures such as horizontal placement in order to keep the height of the tall component 50 low. Therefore, mounting can be performed without increasing the mounting area.

The first filter 10 is provided at an input stage when the traveling battery B1 is charged. The first filter 10 is provided on another board (in the present embodiment, a board on the inverter side) different from the second board 82 and the third board 83. In addition, the second filter 24 is provided at an output stage in the second board 82 when the traveling battery B1 is charged. Furthermore, the third filter 26 is provided at an output stage in the third board 83 when the low-voltage battery B2 is charged. The second filter 24 and the third filter 26 are provided at portions of the individual boards in which noise is relatively strong.

In order to reduce the influence of noise in the first filter 10 on each of the second board 82 and the third board 83, in the present embodiment, the distance between the first filter 10 and the second filter 24 provided on the second board 82 and the distance between the first filter 10 and the third filter 26 provided on the third board 83 are set to be longer than the distance between the second filter 24 and the third filter 26. As a result, the influence of the noise in the first filter 10 on each of the second board 82 and the third board 83 can be reduced.

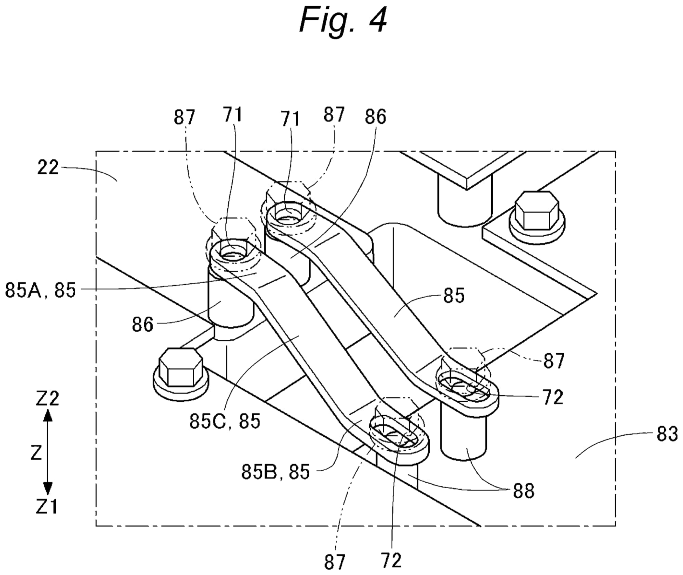

The transformer 22 is connected to each of the second board 82 and the third board 83 using a connecting member 85. Fig. 4 illustrates the connecting member 85 that connects the transformer 22 and the third board 83. As described above, the position along the Z direction of the transformer 22 is different from the position along the Z direction of the third board 83. Therefore, in order to fill the difference between the positions along the Z direction, the connecting member 85 is connected to the transformer 22 via a terminal 85A on one end side and is connected to the third board 83 via a terminal 85B on the other end side. In addition, the connecting member 85 has an inclined portion 85C inclined with respect to the Z direction between the terminal 85A and the terminal 85B.

A circular hole 71 is provided on the terminal 85A side, and an elongated hole 72 with an elongated hole shape is provided on the terminal 85B side. A spacer 86 is provided between the terminal 85A and the transformer 22 along the Z direction. The terminal 85A and the transformer 22 are fastened and fixed via a bolt 87 inserted through the hole 71 and the spacer 86. In addition, a spacer 88 is provided between the terminal 85B and the third board 83 along the Z direction. The terminal 85B and the transformer 22 are fastened and fixed via a bolt 87 inserted through the elongated hole 72 and the spacer 88. At this time, the positional difference (the positional shift) between the transformer 22 and the third board 83 along the Z direction can be absorbed by the inclined portion 85C, and the positional difference (the positional shift) between the transformer 22 and the third board 83 along the XY directions can be absorbed by the elongated hole 72. As a result, the transformer 22 and the third board 83 can be appropriately connected.

Although the connection between the transformer 22 and the third board 83 is described in Fig. 4, the same applies to the connection between the transformer 22 and the second board 82.

### [Other Embodiments]

Next, other embodiments of the power supply module 1 will be described.

The above embodiment has described that the voltage conversion unit 20 further includes the third conversion unit 25, and the power supply module 1 further includes the third board 83 in which the third conversion unit 25 is provided. However, in the power supply module 1, the voltage conversion unit 20 can be configured not to include the third conversion unit 25. In this case, the third board 83 need not to be provided.

The above embodiment has described that the first board 81, the second board 82, and the third board 83 are arranged around the transformer 22 so as to surround the transformer 22 in a state of having at least portions not overlapping each other as viewed in the Z direction. However, the first board 81, the second board 82, and the third board 83 may be arranged around the transformer 22 in a state where at least any two boards completely overlap each other as viewed in the Z direction. Furthermore, the first board 81, the second board 82, and the third board 83 need not to be arranged around the transformer 22 as viewed in the Z direction (may be arranged so as not to surround the transformer 22).

The above embodiment has described that the first board 81, the second board 82, and the third board 83 are arranged in a state where their positions along the Z direction are different from each other as viewed in the Y direction. However, the first board 81, the second board 82, and the third board 83 may be arranged in a state where at least any two boards are arranged at the same position along the Z direction as viewed in the Y direction.

The above embodiment has described that each of the first board 81, the second board 82, and the third board 83 is supported by the support 103 erected from the bottom surface 102 of the housing 101. However, each of the first board 81, the second board 82, and the third board 83 may be supported by being suspended from the lid portion on the side opposite to the bottom surface 102 in the housing 101, or may be supported by an inner wall portion of the housing 101. Note that, in a case where the first board 81, the second board 82, and the third board 83 are supported by being suspended from the lid portion, for example, a portion that is erected from the bottom surface 102 of the housing 101 and supports the lid portion, the lid portion, and a portion in which the lid portion supports the boards 81,82, and 83 correspond to the support 103. In a case where the first board 81, the second board 82, and the third board 83 are supported by the inner wall portion of the housing 101, for example, the inner wall portion erected from the bottom surface 102 of the housing 101 corresponds to the support 103.

The above embodiment has described that the first board 81, the second board 82, and the third board 83 are arranged in descending order of applied potential from the side opposite to the bottom surface 102 of the housing 101. However, the first board 81, the second board 82, and the third board 83 may be arranged in ascending order of applied potential from the side opposite to the bottom surface 102 of the housing 101, or may be arranged regardless of the potential.

The above embodiment has described that the control board 84 is disposed on the side opposite to the bottom surface 102 of at least one of the first board 81, the second board 82, and the third board 83 that is the closest to the bottom surface 102 of the housing 101. However, the control board 84 need not to be disposed on the side opposite to the bottom surface 102 of at least one of the first board 81, the second board 82, and the third board 83 that is the closest to the bottom surface 102 of the housing 101.

The above embodiment has described that the space heat insulating portion 90 that suppresses mutual heat transfer is provided between at least one of the first board 81, the second board 82, and the third board 83 and the transformer 22. However, the space heat insulating portion 90 need not to be provided between at least one of the first board 81, the second board 82, and the third board 83 and the transformer 22.

The above embodiment has described that the space heat insulating portion 90 is provided between the transformer and a region having a high heat generation density in at least one of the first board 81, the second board 82, and the third board 83. However, the space heat insulating portion 90 may be provided between the transformer and a region different from the region having a high heat generation density in at least one of the first board 81, the second board 82, and the third board 83.

The above embodiment has described that the connecting member 85 connecting the transformer 22 and each of any two of the first board 81, the second board 82, and the third board 83 includes the circular hole 71 at one end and the elongated hole 72 with an elongated hole shape at the other end. However, the connecting member 85 may include an elongated hole with an elongated hole shape at one end and a circular hole at the other end. In addition, the circular hole may be formed at both the one end and the other end, or the elongated hole may be formed at both the one end and the other end. Furthermore, the connecting member 85 is not limited to one including the circular hole 71 at one end and the elongated hole 72 with an elongated hole shape at the other end. The connecting member 85 is not particularly limited as long as it can absorb the positional shift between the transformer 22 and each of two of the first board 81, the second board 82, and the third board 83 other than the one fixed to the transformer 22, and for example, a flexible bus bar or the like may be used. Moreover, the transformer 22 may be connected to each of the first board 81, the second board 82, and the third board 83 by the connecting member 85.

The above embodiment has described that the distance between the first filter 10 provided on another board different from the second board 82 and the third board 83 and the second filter 24 provided on the second board 82, and the distance between the first filter 10 and the third filter 26 provided on the third board 83 are longer than the distance between the second filter 24 and the third filter 26. However, the distance between the first filter 10 and the second filter 24 provided on the second board 82 and the distance between the first filter 10 and the third filter 26 provided on the third board 83 may be the same as or shorter than the distance between the second filter 24 and the third filter 26.

The above embodiment has described that, in the control board 84, the relatively tall component 50 among the components provided on the control board 84 is provided in the region 91 in the control board 84 facing one of the first board 81, the second board 82, and the third board 83 that is the closest to the bottom surface 102 of the housing 101. However, in the control board 84, the relatively tall component 50 among the components provided on the control board 84 need not to be provided in the region 91 in the control board 84 facing one of the first board 81, the second board 82, and the third board 83 that is the closest to the bottom surface 102 of the housing 101.

### [Outline of Embodiment]

Hereinafter, the outline of the power supply module 1 described above will be described.

The power supply module 1 is the power supply module 1 mounted on a vehicle, the power supply module 1 including the AC-DC conversion unit 11 that converts one of an AC voltage and a DC voltage into the other and outputs the other, and the voltage conversion unit 20 that converts a first voltage value of an input DC voltage into a DC voltage having a second voltage value, the voltage conversion unit 20 includes the first conversion unit 21 connected to the AC-DC conversion unit 11 and the second conversion unit 23 connected to the first conversion unit 21 via the transformer 22, and the power supply module including the first board 81 on which the AC-DC conversion unit 11 and the first conversion unit 21 are provided, and the second board 82 on which the second conversion unit 23 is provided and that is different from the first board 81.

According to this configuration, the first board 81 on which the AC-DC conversion unit 11 and the first conversion unit 21 are provided and the second board 82 on which the second conversion unit 23 is provided, the first board and the second board being configured via the transformer 22, can be configured separately. Therefore, the first board 81 and the second board 82 can be easily assembled and inspected, and handling can be easily performed in a manufacturing process and an inspection process. In addition, since the layer configurations of the first board 81 and the second board 82 and the thickness of the conductor layer can be set depending on the specifications of the AC-DC conversion unit 11, the first conversion unit 21, and the second conversion unit 23, it is possible to configure each board at low cost. In addition, one of the first board 81 and the second board 82 can be changed to cope with the situation depending on the specifications, so that it is possible to easily cope with the serialization of a lineup of the power supply modules 1.

(2) In the power supply module 1 described in (1), it is preferable that the voltage conversion unit 20 further include a third conversion unit 25 that is connected to the first conversion unit 21 via the transformer 22 and converts into a DC voltage having a third voltage value, and the power supply module further include a third board 83 on which the third conversion unit 25 is provided and that is different from the first board 81 and the second board 82.

According to this configuration, the third board 83 on which the third conversion unit 25 is provided can be further provided separately from the first board 81 and the second board 82 described above. Therefore, similarly to the first board 81 and the second board 82, handling can be easily performed, and the third board 83 can be configured at low cost.

(3) In the power supply module 1 described in (2), the first board 81, the second board 82, and the third board 83 are preferably arranged around the transformer 22 in a state of having at least portions not overlapping each other as viewed in the Z direction (the first direction) along the thickness direction.

According to this configuration, each of the first board 81, the second board 82, and the third board 83 is connected to the transformer 22. Therefore, each of the first board 81, the second board 82, and the third board 83 can be connected to the transformer 22 at the shortest distance by being arranged around the transformer 22. In addition, it is also possible to suppress the intersection between the wires.

(4) In the power supply module 1 described in (2) or (3), the first board 81, the second board 82, and the third board 83 are preferably arranged in a state where positions of the first board, the second board, and the third board along the Z direction are different from each other as viewed in the Y direction (the second direction) orthogonal to the Z direction.

According to this configuration, since the positions in the Z direction of the first board 81, the second board 82, and the third board 83 are different from each other, the insulation distance of each of the first board 81, the second board 82, and the third board 83 can be secured. Therefore, it is possible to take measures against insulation at low cost.

(5) In the power supply module 1 described in any one of (2) to (4), it is preferable that each of the first board 81, the second board 82, and the third board 83 be supported by the support 103 erected from the bottom surface 102 of the housing 101, and the first board 81, the second board 82, and the third board 83 be arranged in descending order of applied potential from the side opposite to the bottom surface 102.

According to this configuration, for example, when a conductive foreign substance is generated, the conductive foreign substance rolls down to the low potential side, so that the insulation robustness is superior. Therefore, the insulation robustness against the conductive foreign substance can be improved.

(6) In the power supply module 1 described in any one of (2) to (5), it is preferable that each of the first board 81, the second board 82, and the third board 83 be supported by the support 103 erected from the bottom surface 102 of the housing 101, and the control board 84 including the control unit 30 that controls driving of the AC-DC conversion unit 11 and the voltage conversion unit 20 be disposed on the side opposite to the bottom surface 102 of at least one of the first board 81, the second board 82, and the third board 83 that is the closest to the bottom surface 102.

According to this configuration, the control board 84 can be disposed using the free space on the side opposite to the board closest to the bottom surface 102 of the housing 101 among the first board 81, the second board 82, and the third board 83. Therefore, it is possible to prevent an increase in size of the power supply module 1. Furthermore, the connection distance with each of the first board 81, second board 82, and the third board 83 can be shortened, and the intersection with a high-voltage line (a power supply line with a high applied voltage) can be reduced, so that noise resistance can be improved.

(7) In the power supply module 1 described in any one of (2) to (6), the space heat insulating portion 90 that suppresses mutual heat transfer is preferably provided between at least one of the first board 81, the second board 82, and the third board 83 and the transformer 22.

According to this configuration, the influence of the heat of the transformer 22 on the surroundings can be reduced. Therefore, it is possible to reduce thermal stress on the components provided on each of the first board 81, the second board 82, and the third board 83.

(8) In the power supply module 1 described in (7), the space heat insulating portion 90 is preferably provided between the transformer 22 and the region having a high heat generation density in at least one of the first board 81, the second board 82, and the third board 83.

According to this configuration, since the space heat insulating portion 90 is provided adjacent to the region having a high heat generation density, the influence of heat on the surroundings can be reduced.

(9) In the power supply module 1 according to any one of (2) to (8), the connecting member 85 that connects the transformer 22 and each of any two of the first board 81, the second board 82, and the third board 83 preferably includes the circular hole 71 at one end and the elongated hole 72 with an elongated hole shape at the other end.

According to this configuration, the elongated hole 72 can absorb the positional shift between the transformer 22 and each of any two of the first board 81, the second board 82, and the third board 83. Therefore, it is possible to easily perform assembly.

(10) In the power supply module 1 described in any one of (2) to (9), the distance between the first filter 10 provided on another board different from the second board 82 and the third board 83 and the second filter 24 provided on the second board 82, and the distance between the first filter 10 and the third filter 26 provided on the third board 83 are preferably longer than the distance between the second filter 24 and the third filter 26.

According to this configuration, the influence of the noise generated in the first filter 10 on each of the second board 82 and the third board 83 can be reduced.

(11) In the power supply module 1 described in (6), also in combination with (7) to (10), in the control board 84, the relatively tall component 50 among components provided on the control board 84 is preferably provided in a region in the control board 84 facing one of the first board 81, the second board 82, and the third board 83 that is the closest to the bottom surface 102.

According to this configuration, it is possible to secure the space for disposing the tall component 50 provided on the control board 84. Therefore, it is not necessary to take measures such as mounting the tall component 50 on its side, and the increase in mounting area can be prevented.

The technology according to the present disclosure can be used for a power supply module mounted on a vehicle.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A power supply module (1) mounted on a vehicle, the power supply module (1) comprising: an AC-DC conversion unit (11) that converts one of an AC voltage and a DC voltage into the other and outputs the other; and a voltage conversion unit (20) that converts a first voltage value of an input DC voltage into a DC voltage having a second voltage value, wherein
the voltage conversion unit (20) includes a first conversion unit (21) connected to the AC-DC conversion unit (11) and a second conversion unit (23) connected to the first conversion unit (21) via a transformer (22), and
the power supply module (1) comprising: a first board (81) on which the AC-DC conversion unit (11) and the first conversion unit (21) are provided; and
a second board (82) on which the second conversion unit (23) is provided and that is different from the first board (81).

2. The power supply module (1) according to Claim 1, wherein the voltage conversion unit (20) further includes a third conversion unit (25) that is connected to the first conversion unit (21) via the transformer (22) and converts into a DC voltage having a third voltage value, and
the power supply module (1) further comprising a third board (83) on which the third conversion unit (25) is provided and that is different from the first board (81) and the second board (82).

3. The power supply module (1) according to Claim 2, wherein the first board (81), the second board (82), and the third board (83) are arranged around the transformer (22) in a state of having at least portions not overlapping each other as viewed in a first direction along a thickness direction.

4. The power supply module (1) according to Claim 2 or 3, wherein the first board (81), the second board (82), and the third board (83) are arranged in a state where positions of the first board (81), the second board (82), and the third board (83) along the first direction are different from each other as viewed in a second direction orthogonal to the first direction.

5. The power supply module (1) according to any one of Claims 2 to 4, wherein each of the first board (81), the second board (82), and the third board (83) is supported by a support (103, 103A, 103B, 103C) erected from a bottom surface (102) of a housing (101), and
the first board (81), the second board (82), and the third board (83) are arranged in descending order of applied potential from a side opposite to the bottom surface (102).

6. The power supply module (1) according to any one of Claims 2 to 5, wherein each of the first board (81), the second board (82), and the third board (83) is supported by a support (103, 103A, 103B, 103C) erected from a bottom surface (102) of a housing (101), and
a control board (84) including a control unit (30) that controls driving of the AC-DC conversion unit (11) and the voltage conversion unit (20) is disposed on a side opposite to the bottom surface (102) of at least one of the first board (81), the second board (82), and the third board (83) that is the closest to the bottom surface (102).

7. The power supply module (1) according to any one of Claims 2 to 6, wherein a space heat insulating portion (90) that suppresses mutual heat transfer is provided between at least one of the first board (81), the second board (82), and the third board (83) and the transformer (22).

8. The power supply module (1) according to Claim 7, wherein the space heat insulating portion (90) is provided between the transformer (22) and a region having a high heat generation density in at least one of the first board (81), the second board (82), and the third board (83).

9. The power supply module (1) according to any one of Claims 2 to 8, wherein a connecting member (85) that connects the transformer (22) and each of any two of the first board (81), the second board (82), and the third board (83) includes a circular hole (71) at one end and an elongated hole (72) with an elongated hole shape at the other end.

10. The power supply module (1) according to any one of Claims 2 to 9, wherein a distance between a first filter (10) provided on another board different from the second board (82) and the third board (83) and a second filter (24) provided on the second board (82), and a distance between the first filter (10) and a third filter (26) provided on the third board (83) are longer than a distance between the second filter (24) and the third filter (26).

11. The power supply module (1) according to Claim 6 or according to any one of Claims 7 to 10 if depending on claim 6, wherein in the control board (84), a relatively tall component (50) among components provided on the control board (84) is provided in a region (91) in the control board (84) facing one of the first board (81), the second board (82), and the third board (83) that is the closest to the bottom surface (102).
